Europäisches Patentamt

European Patent Office

Office européen des brevets

(11) Veröffentlichungsnummer: **0 203 602**
**A1**

## (12) EUROPÄISCHE PATENTANMELDUNG

(21) Anmeldenummer: **86107293.2**

(22) Anmeldetag: **28.05.86**

(51) Int. Cl.⁴: **B23K 1/12**

(30) Priorität: **30.05.85 DE 3519418**

(43) Veröffentlichungstag der Anmeldung:
**03.12.86 Patentblatt 86/49**

(84) Benannte Vertragsstaaten:
**AT BE DE FR GB IT NL**

(71) Anmelder: **Siemens Aktiengesellschaft Berlin
und München
Wittelsbacherplatz 2
D-8000 München 2(DE)**

(72) Erfinder: **Gutwirth, Werner, Dipl.-Phys.
Gunzenleestrasse 16 A
D-8901 Kissing(DE)**

(54) **Vorrichtung zum Stapellöten.**

(57) Die Erfindung bezieht auf eine Vorrichtung zum Stapellöten von zu Ösen geformten Drahtenden von Anschlußdrähten auf einer Lötstelle, z.B. einer gedruckten Leiterplatte mit Hilfe eines temperaturgesteuerten Lötwerkzeuges (1). Zum Ausbessern von gedruckten Leiterplatten ist es notwendig, mehrere Rundleiter in einem Knotenpunkt anzulöten. Hierzu sieht die Erfindung vor, daß im Inneren des Lötwerkzeuges (1) ein federnd gelagerter Zentrierstift (2) vertikal verschiebbar und elektrisch vom Lötwerkzeug (1) isoliert angeordnet ist. Damit ist eine Änderung von Leiterplatten in einfacher Weise möglich.

FIG 1

EP 0 203 602 A1

Vorrichtung zum Stapellöten

Die Erfindung betrifft eine Vorrichtung zum Stapellöten von zu Ösen geformten Drahtenden von Anschlußdrähten auf eine Lötstelle.

Aufgabe der vorliegenden Erfindung ist es, eine Lötvorrichtung zu schaffen, durch die ein einwandfreies Festlöten mehrerer übereinander angeordneter Anschlußleiter auf einer Lötstelle, z.B. einer gedruckten Leiterplatte, ermöglicht wird.

Zur Lösung dieser Aufgabe wird gemäß der Erfindung die Lötvorrichtung derart ausgebildet, daß im Innern des Lötwerkzeuges ein federnd gelagerter Zentrierstift vertikal verschiebbar und elektrisch vom Lötwerkzeug isoliert angeordnet ist.

Das Lötwerkzeug kann dabei aus einem sich am unteren Ende verjüngenden, an einem Lötkopf befestigten, automatisch betätigbaren Lötbügel bestehen.

Der Zentrierstift läßt sich dabei in einer elektrisch isolierenden Führung vertikal bewegen.

Durch diese Maßnahmen ist ein einwandfreies Festlöten mehrerer übereinander angeordneter Leiter auf einer Lötstelle möglich. Dadurch können Änderungen der Leiterfiguration auf gedruckten Leiterplatten in einfacher Weise vorgenommen werden.

Anhand der Ausführungsbeispiele nach den Figuren 1 bis 3 wird die Erfindung näher erläutert. Es zeigen

FIG 1 die schematische Darstellung einer Lötvorrichtung mit Zentrierstift,

FIG 2 den Ausschnitt aus einer Leiterplatte mit einem Lötpad und darauf angeordneten ösenförmig ausgebildeten Leiterenden,

FIG 3 einen Querschnitt von einer verlöteten Anordnung nach FIG 2.

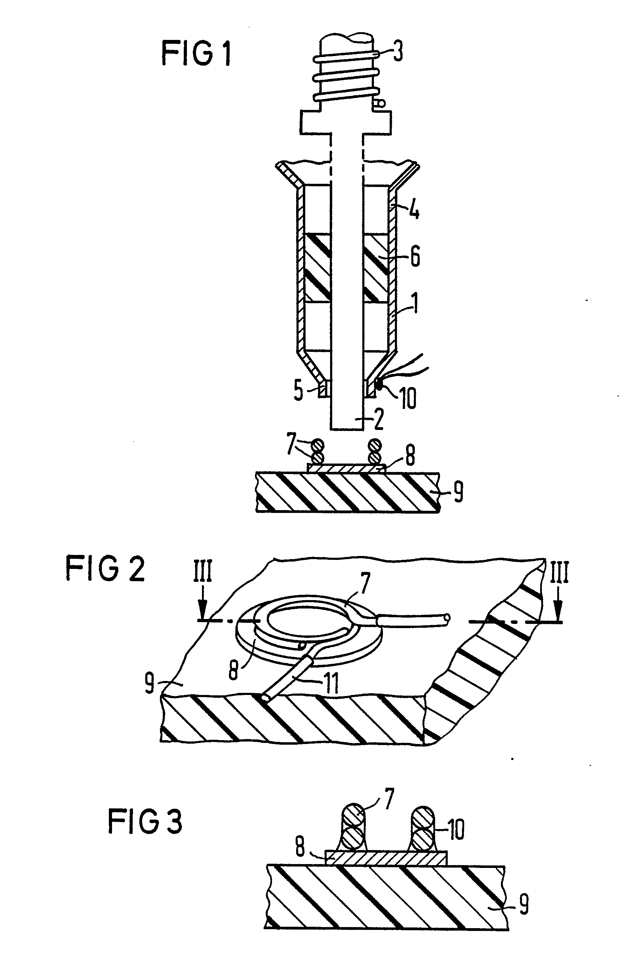

Die Lötvorrichtung 1 nach FIG 1 besteht aus einem automatisch betätigbaren Lötbügel 4, der an seinem unteren Ende in eine Lötspitze 5 ausläuft. Im Hohlraum des Lötbügels 4 befindet sich ein Zentrierstift 2, der durch eine Feder 3 vertikal bewegbar gelagert ist. Der Lötbügel 4 selbst ist an einem in der Figur nicht dargestellten Lötkopf befestigt. Der Zentrierstift 2 wird mit Hilfe der Führung 6, die aus elektrisch isolierendem Material besteht, im Lötbügel 4 geführt. An der Spitze 5 ist ein Thermoelement 10 zur Temperatursteuerung angeschweißt. Unterhalb des Zentrierstiftes 2 ist ein Teil einer Leiterplatte 9, auf der sich ein Lötpad 8 befindet, dargestellt.

Auf dem Lötpad 8 sind, wie in FIG 2 dargestellt, zwei Enden von Lötdrähten angeordnet, die jeweils in eine Öse 7 ausgeformt sind. Der Einfachheit halber sind nur zwei Ösen übereinander gezeichnet, es können jedoch mehrere derartige Ösen an ein und derselben Lötstelle befestigt werden. Der im elektrisch beheizten Lötbügel 4 integrierte Zentrierstift 2 dient dazu, die zu Ösen 7 vorgeformten Drahtenden oder die bei Endlosdraht von der Spule direkt auf dem Stift gebildeten Drahtschlaufen exakt zu führen, um ein Übereinanderlöten der Drähte zu ermöglichen.

In FIG 3 sind im Querschnitt zwei bereits mit dem zugehörigen Lötpad verlötete Schlaufen gezeigt, wobei das Lötzinn 10 die beiden Schlaufen stetig umhüllt.

**Ansprüche**

Vorrichtung zum Stapellöten von zu Ösen geformten Drahtenden von Anschlußdrähten auf eine Lötstelle, z.B. einer gedruckten Leiterplatte mit Hilfe eines temperaturgesteuerten Lötwerkzeuges, **dadurch gekennzeichnet,** daß im Innern des Lötwerkzeuges (1) ein federnd gelagerter Zentrierstift (3) vertikal verschiebbar und elektrisch vom Lötwerkzeug (1) isoliert angeordnet ist.

2. Vorrichtung nach Anspruch 1, **dadurch gekennzeichnet,** daß das Lötwerkzeug (1) aus einer sich am unteren Ende verjüngenden, an einem Lötkopf befestigten, automatisch betätigbaren Lötbügel (4) besteht.

3. Vorrichtung nach Anspruch 1 oder 2, **dadurch gekennzeichnet** , daß zwischen Lötbügelinnenwand und Zentrierstift eine elektrisch isolierende Führung (6) vorgesehen ist.

0 203 602

FIG 1

FIG 2

FIG 3

## EUROPÄISCHER RECHERCHENBERICHT

Nummer der Anmeldung

EP 86107293.2

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US - A - 4 300 715 (KEIZER) <br> * Fig. 5-9 * <br> ---- | 1 | B 23 K 1/12 |

**RECHERCHIERTE SACHGEBIETE (Int. Cl.4)**

B 23 K 1/00
B 23 K 3/00
B 23 K 31/00
H 05 K 3/00
H 01 R 4/00
H 01 R 43/00

Der vorliegende Recherchenbericht wurde für alle Patentansprüche erstellt.

| Recherchenort | Abschlußdatum der Recherche | Prüfer |
|---|---|---|
| WIEN | 04-09-1986 | BENCZE |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein- stimmendes Dokument

EPA Form 1503 03 82